# EUROPEAN PATENT APPLICATION

(11) **EP 4 800 927 A1**
(43) Date of publication of application: **02.09.2026**
(21) Application number: 23956862.9
(22) Date of filing: 27.10.2023
(51) Int. Cl.: H03M 13/13, H04L 1/00

(54) **COMMUNICATION DEVICE AND COMMUNICATION METHOD**

(71) Applicant: NTT DOCOMO, INC., Tokyo 100-6150 (JP)
(72) Inventor: OBARA, Tatsunori, Tokyo 100-6150 (JP); SHIBAIKE, Naoya, Tokyo 100-6150 (JP); MARUMO, Ryo, Tokyo 100-6150 (JP); NAGATA, Satoshi, Tokyo 100-6150 (JP); MIKI, Nobuhiko, Takamatsu-shi, Kagawa 761-0396 (JP)
(74) Representative: Hoffmann Eitle
(86) International application number: PCT/JP2023/038989
(87) International publication number: WO 2025/088812

(57) **Abstract**

A terminal includes: a control unit configured to perform coding of information bits by using Polar codes; and a transmission unit configured to transmit coded words corresponding to the information bits to another communication device. The control unit determines positions of known bits that are added at a time of the coding of the information bits, based on a specific condition.

## Description

### TECHNICAL FIELD

The present invention relates to a communication device and a communication method in a wireless communication system.

### BACKGROUND ART

In 3GPP (registered trademark) (3rd Generation Partnership Project), in order to realize further larger system capacity, further faster data transmission speed, further lower latency in a wireless communication section, etc., a wireless communication method called "5G" or "NR (New Radio)" is being discussed (hereinafter, the wireless communication method is referred to as "NR"). In 5G, various wireless technologies and network architectures are being discussed to satisfy the requirements of a radio link delay of 1 ms or less while achieving throughput of 10 Gbps or more (e.g., Non-Patent Literature 1 and Non-Patent Literature 2).

In addition, various requirements for the next generation "6G" are being discussed. For example, the requirements include ultra broadband communication, mission critical communication, ultra massive connection, universal coverage, intelligent connection, ubiquitous sensing, and the like.

In order to satisfy the above-described requirements, as a new concept, the goals are set to be extensible (for example, capable of being effectively used in the future), easy-operational, customizable (for example, capable of being easily operational), and sustainable (for example, capable of reducing cost, capable of having a robust structure, capable of having resilience). In addition, as a guaranteed communication, always guaranteeing the minimum performance is being discussed.

### CITATION LIST

### Non-Patent Literature

Non-Patent Literature 1: 3GPP TS 38.300 V17.6.0 (2023-09)
Non-Patent Literature 2: 3GPP TS 38.401 V17.6.0 (2023-09)
Non-Patent Literature 3: E. Arikan, "A Short Course on Polar Coding Theory and Applications"
Non-Patent Literature 4: 3GPP TS 38.212 V17.6.0 (2023-09)

### SUMMARY OF INVENTION

### TECHNICAL PROBLEM

In NR, Polar coding is adopted (refer to Non-Patent Literature 3 and Non-Patent Literature 4). When applying the Polar coding to the data channel, there are Successive Cancellation (SC) Decoding and Brief Propagation (BP) Decoding as decoding methods. Here, there is a case in which the processing delay increases in proportion to the information bit sequence length in the Successive Cancellation Decoding and there is a case in which the characteristics are degraded in the Brief Propagation Decoding.

The present invention has been made in view of the above points, and it is an object of the present invention to improve the characteristics of the Polar coding methods in the wireless communication system.

### SOLUTION TO PROBLEM

According to the disclosed technique, a communication device is provided. The communication device includes: a control unit configured to perform coding of information bits by using Polar codes; and a transmission unit configured to transmit coded words corresponding to the information bits to another communication device. The control unit determines positions of known bits that are added at a time of the coding of the information bits, based on a specific condition.

### ADVANTAGEOUS EFFECTS OF INVENTION

According to the disclosed technique, characteristics of the Polar coding method can be improved in the wireless communication system.

### BRIEF DESCRIPTION OF DRAWINGS

[Fig. 1] is a drawing illustrating a configuration example of a wireless communication system in an embodiment of the present invention.
[Fig. 2] is a drawing for describing an example of the channel polarization.
[Fig. 3] is a drawing for describing an example (1) of Polar coding.
[Fig. 4] is a drawing for describing an example (2) of Polar coding.
[Fig. 5] is a drawing for describing an example of decoding according to Successive Cancellation Decoding.
[Fig. 6] is a drawing for describing an example of successive processing and parallel processing.
[Fig. 7] is a drawing for describing an example (1) of decoding according to Brief Propagation Decoding.
[Fig. 8] is a drawing for describing an example (2) of decoding according to Brief Propagation Decoding.
[Fig. 9] is a drawing for describing an example (3) of decoding according to Brief Propagation Decoding.
[Fig. 10] is a drawing for describing processing delays of Successive Cancellation Decoding and Brief Propagation Decoding.
[Fig. 11] is a flowchart illustrating an operation example (1) related to coding processes in an embodiment of the present invention.
[Fig. 12] is a flowchart illustrating an operation example (2) related to coding processes in an embodiment of the present invention.
[Fig. 13] is a flowchart illustrating an operation example (3) related to coding processes in an embodiment of the present invention.
[Fig. 14] is a flowchart illustrating an operation example (4) related to coding processes in an embodiment of the present invention.
[Fig. 15] is a drawing illustrating an example of a functional structure of a base station 10 in an embodiment of the present invention.
[Fig. 16] is a drawing illustrating an example of a functional configuration of a terminal 20 in an embodiment of the present invention.
[Fig. 17] is a drawing illustrating an example of a hardware structure of the base station 10 or the terminal 20 in an embodiment of the present invention.
[Fig. 18] is a drawing illustrating an example of a structure of a vehicle 2001 in an embodiment of the present invention.

### DESCRIPTION OF EMBODIMENTS

In the following, while referring to the drawings, one or more embodiments of the present invention will be described. It should be noted that the embodiments described below are examples. Embodiments of the present invention are not limited to the following embodiments.

In operations of a wireless communication system according to an embodiment of the present invention, a conventional technique will be used when it is appropriate. It should be noted that, although the conventional techniques may be the conventional LTE, the conventional techniques are not limited to the conventional LTE. Further, it is assumed that the term "LTE" used in the present specification has, unless otherwise specifically mentioned, a broad meaning including a scheme of LTE-Advanced and a scheme after LTE-Advanced (e.g., NR).

Furthermore, in one or more embodiments described below, terms that are used in the existing LTE are used, such as SS (Synchronization signal), PSS (Primary SS), SSS (Secondary SS), PBCH (Physical broadcast channel), PRACH (Physical random access channel), PDCCH (Physical Downlink Control Channel), PDSCH (Physical Downlink Shared Channel), PUCCH (Physical Uplink Control Channel), PUSCH (Physical Uplink Shared Channel), etc. The above-described terms are used for the sake of description convenience. Signals, functions, etc., which are similar to the above-described terms, may be referred to as different names. In addition, the above-described terms in NR correspond to NR-SS, NR-PSS, NR-SSS, NR-PBCH, NR-PRACH, etc. However, even when a signal is used for NR, the signal is not required to be referred to as "NR-".

In addition, in an embodiment of the present invention, the duplex method may be a TDD (Time Division Duplex) method, an FDD (Frequency Division Duplex) method, or any other method (e.g., Flexible Duplex, or the like).

Further, in an embodiment of the present invention, the expression that a radio parameter, or the like is "configured" may mean that a predetermined value is pre-configured, or may mean that a radio parameter indicated by a base station 10 or a terminal 20 is configured.

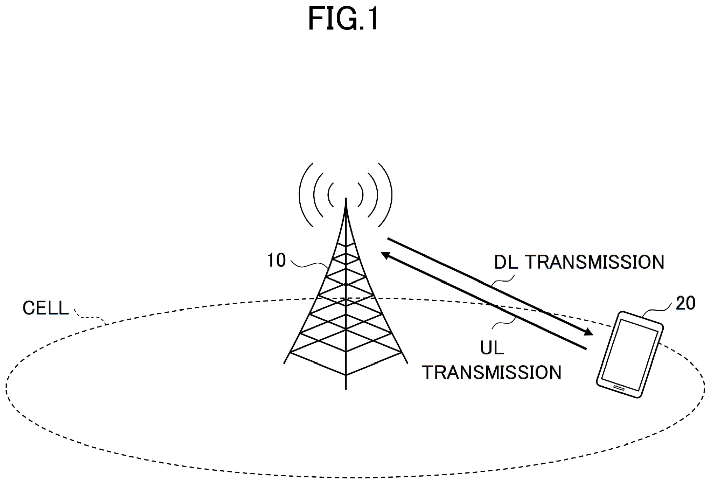

Fig. 1 is a drawing illustrating a configuration example of a wireless communication system according to an embodiment of the present invention. As illustrated in Fig. 1, a wireless communication system according to an embodiment of the present invention includes a base station 10 and a terminal 20. In Fig. 1, a single base station 10 and a single terminal 20 are illustrated as an example, but there may be a plurality of base stations 10 and a plurality of terminals 20.

The base station 10 is a communication device that provides one or more cells and performs wireless communication with the terminal 20. Physical resources of radio signals may be defined in the time domain and the frequency domain, the time domain may be defined by the number of OFDM (Orthogonal Frequency Division Multiplexing) symbols, and the frequency domain may be defined by the number of sub-carriers or resource blocks. The base station 10 transmits a synchronization signal and system information to the terminal 20. The synchronization signal is, for example, an NR-PSS and/or an NR-SSS. The system information may be transmitted via an NR-PBCH, and may be referred to as broadcast information. The synchronization signal and the system information may be referred to as an SSB (SS/PBCH block). As shown in Fig. 1, the base station 10 transmits a control signal or data in DL (Downlink) to the terminal 20 and receives a control signal or data in UL (Uplink) from the terminal 20. The base station 10 and terminal 20 are capable of transmitting and receiving a signal by performing the beamforming. Further, the base station 10 and the terminal 20 can both apply MIMO (Multiple Input Multiple Output) communication to DL or UL. Further, the base station 10 and the terminal 20 may both perform communications via a secondary cell (SCell: Secondary Cell) and a primary cell (PCell: Primary Cell) using CA (Carrier Aggregation). In addition, the terminal 20 may perform communications via a primary cell of the base station 10 and a primary secondary cell group cell (PSCell: Primary SCG Cell) of another base station 10 using DC (Dual Connectivity).

The terminal 20 may be a communication apparatus that includes a wireless communication function such as a smartphone, a mobile phone, a tablet, a wearable terminal, a communication module for M2M (Machine-to-Machine), or the like. As shown in Fig. 1, the terminal 20 uses various communication services provided by the wireless communication system by receiving control signals or data in DL from the base station 10 and transmitting control signals or data in UL to the base station 10. In addition, the terminal 20 receives various reference signals transmitted from the base station 10 and performs measurement of the propagation path quality based on the reception result of the reference signals.

In addition, various requirements for the next generation "6G" are being discussed. For example, the requirements may include the ultra broadband communication, the mission critical communication, the ultra massive connection, the universal coverage, the intelligent connection, the ubiquitous sensing, and the like.

In addition, the requirements may include the ultra high speed communication, the large capacity communication, the ultra coverage enhancement, the ultra low energy consumption, the low cost, the ultra low latency, the ultra high reliability communication, the ultra many connection and sensing, and the like.

In order to satisfy the above-described requirements, as a new concept, the goals are set to be extensible (for example, capable of being effectively used in the future), easy-operational, customizable (for example, capable of being easily operational), and sustainable (for example, capable of reducing cost, capable of having a robust structure, capable of having resilience). In addition, as a guaranteed communication, always guaranteeing the minimum performance is being discussed.

In addition, as one of the important elemental technologies, there is error correction coding. The Polar coding can be listed as a candidate for error correction coding that can satisfy the above-described requirements (refer to Non-Patent Literature 3).

Polar coding is coding that can achieve error characteristics that asymptotically approach the Shannon limit by using channel polarization. In 5G NR, Polar coding is adopted as error correction coding of data channels. Polar coding is expected to be a promising candidate for error correction coding also in 6G.

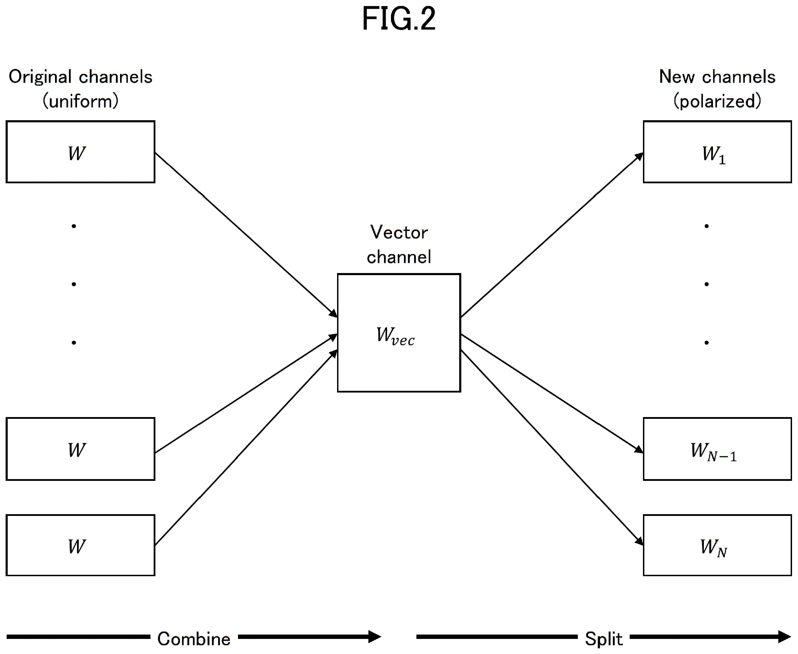

Fig. 2 is a drawing for describing an example of the channel polarization (refer to Non-Patent Literature 3). As illustrated in Fig. 2, in the channel polarization, uniform original channels are converted to polarized new channels by having the uniform original channels combined and split.

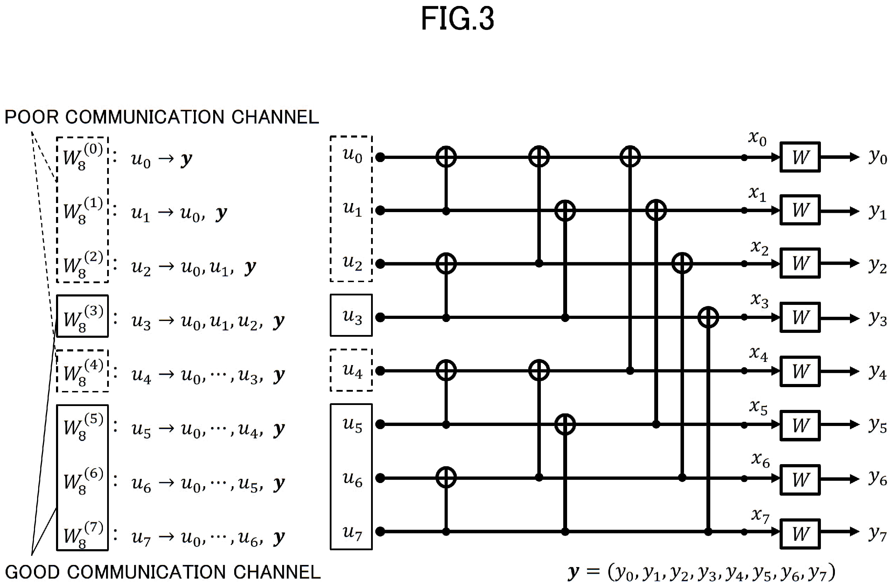

Fig. 3 is a drawing for describing an example (1) of Polar coding. As illustrated in Fig. 3, in Polar coding, uniform original channels are converted to polarized new channels with good communication channels and poor communication channels by having the uniform original channels combined and split. In an example of Polar coding illustrated in Fig. 3, the poor communication channels are W₈⁽⁰⁾, W₈⁽¹⁾, W₈⁽²⁾, and W₈⁽⁴⁾, and the good communication channels are W₈⁽³⁾, W₈⁽⁵⁾, W₈⁽⁶⁾, and W₈⁽⁷⁾.

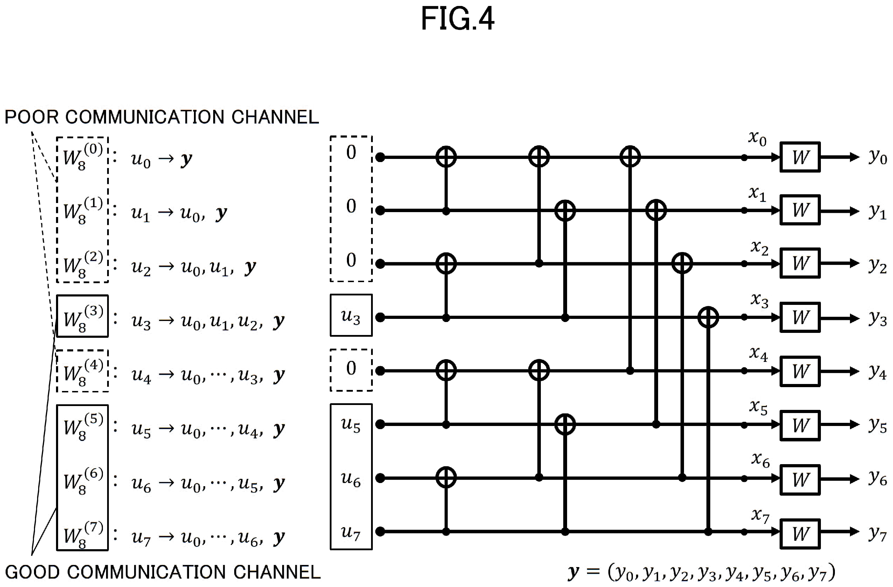

Fig. 4 is a drawing for describing an example (2) of Polar coding. In Polar coding, a frozen bit, that is, a redundant bit that is known to the transmission side and the reception side, such as 0, is input to the poor communication channels. Excellent characteristics are achieved by inputting information bits to the good communication channels. The coding rate can be changed by changing the number of frozen bits. In an example of Fig. 4, an example of a case including four bits of frozen bits and four bits of information bits in which the coding rate R is equal to 1/2 is illustrated. As illustrated in Fig. 4, the frozen bit 0 is input to the poor communication channels W₈⁽⁰⁾, W₈⁽¹⁾, W₈⁽²⁾, and W₈⁽⁴⁾.

In Successive Cancellation Decoding, polarized channels are successively decoded. Frozen bits are not required to be decoded because the frozen bits are known to the transmission side and the reception side. Decoding of an information bit requires a preceding decoding result, and thus, the decoding is performed successively in the order of preceding information bits.

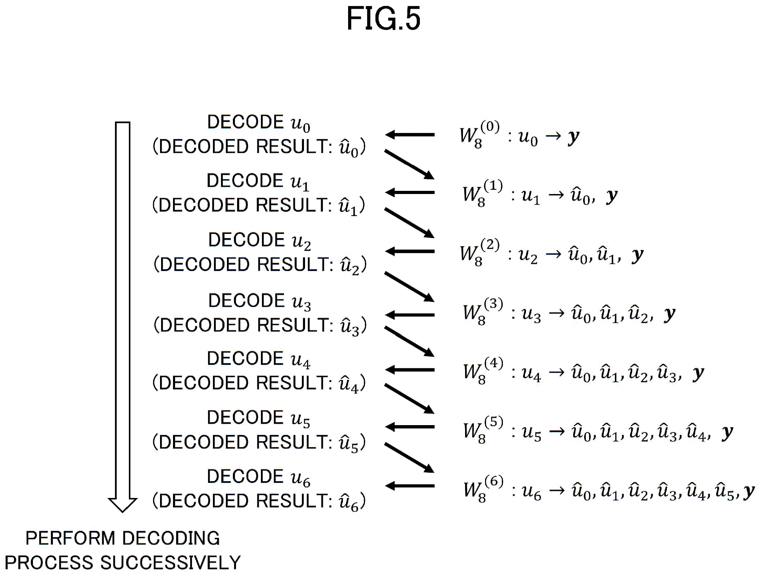

Fig. 5 is a drawing for describing an example of decoding according to Successive Cancellation Decoding. Fig. 5 illustrates an example of decoding of the sixth channel in the eight-channel polarization. As illustrated in Fig. 5, in order to decode u₆, u₀, u₁, u₂, u₃, u₄, and u₅ are required to be known in advance. Decoding of u₁ is performed based on the decoding result of u₀, and then, decoding of u₂ is performed based on the decoding results of u₀ and u₁. In this way, the decoding processing is performed successively.

In Successive Cancellation Decoding, there is a fundamental processing delay due to the successive processing. In Successive Cancellation Decoding, decoding is performed successively by using a decoding result of the preceding information bit, and thus, there are characteristics in which the fundamental processing delay increases proportionally as the information bit sequence length increases.

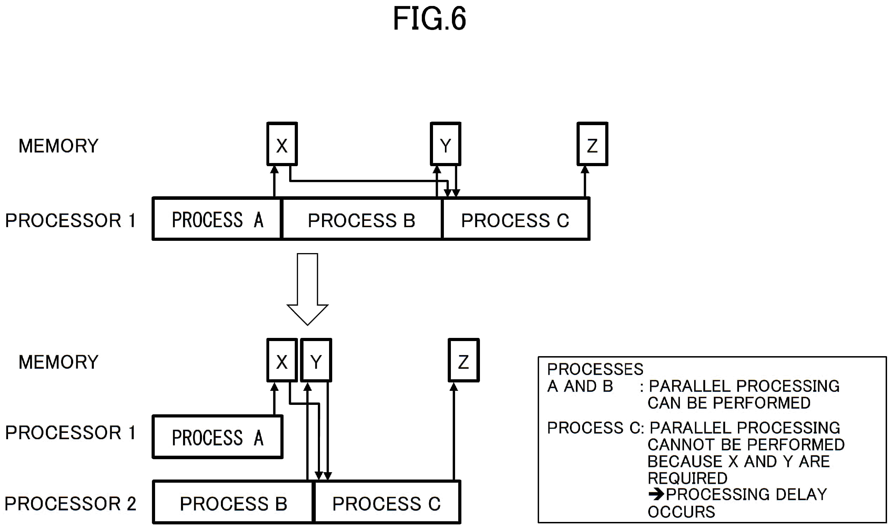

Fig. 6 is a drawing for describing an example of successive processing and parallel processing. As illustrated in Fig. 6, in a case where a final output Z is obtained by performing the process C by using the result X and the result Y of the process A and the process B, the process A, the process B, and the process C are performed in this order in the successive processing. On the other hand, in a case where the process A and the process B can be processed in parallel, the processing delay is smaller as compared with that of successive processing because the process A and the process B can be processed in parallel as illustrated in Fig. 6. However, the process C requires the result X and the result Y, and thus, the process C cannot be processed in parallel with the process A and the process B. Therefore, the processing delay occurs. Accordingly, application of Brief Propagation Decoding that enables significant reduction of the processing delay according to the parallel processing will be discussed.

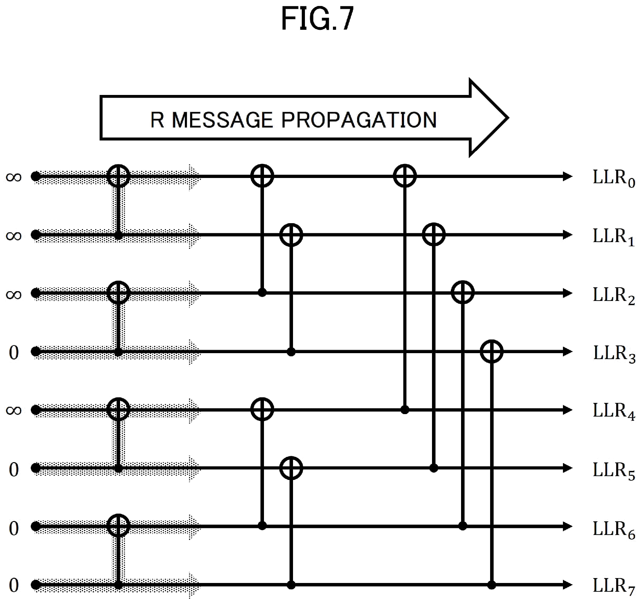

Fig. 7 is a drawing for describing an example (1) of decoding according to Brief Propagation Decoding. In Brief Propagation Decoding, propagation of the Log Likelihood Ratio (LLR) that is referred to as a message is performed. As illustrated in Fig. 7, first, propagation of R message from left to right is performed. The left end message is initialized in which the frozen bit is infinity and the information bit is 0.

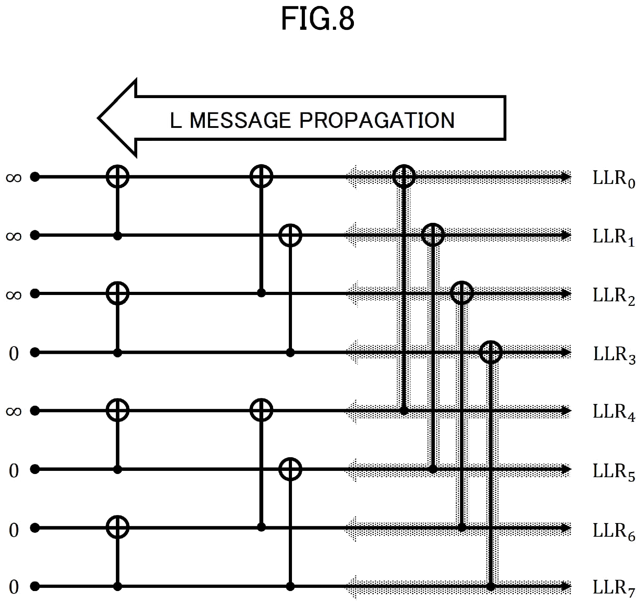

Fig. 8 is a drawing for describing an example (2) of decoding according to Brief Propagation Decoding. After the process illustrated in Fig. 7, propagation of L message from right to left is performed. The right end message is initialized as an LLR of a reception signal y.

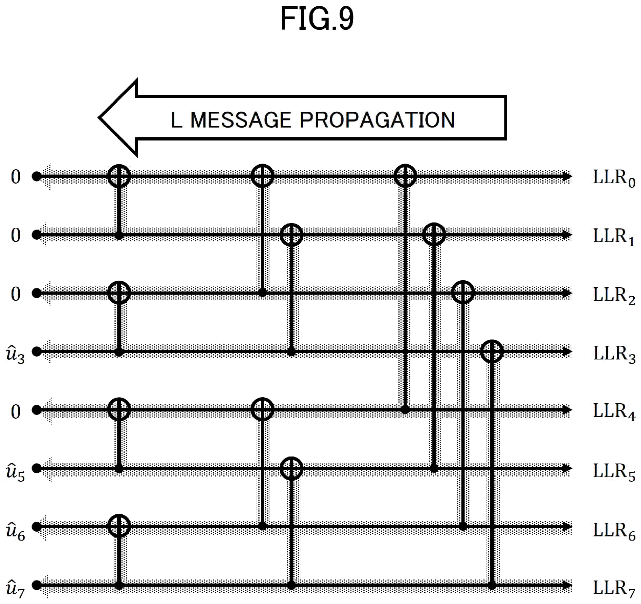

Fig. 9 is a drawing for describing an example (3) of decoding according to Brief Propagation Decoding. The processes illustrated in Fig. 7, Fig. 8, and Fig. 9 are counted as one iteration, and a decoding result with high accuracy is output by performing T iterations. Because of the parallel processing, the processing delay of Brief Propagation Decoding is proportional with the number of iterations T.

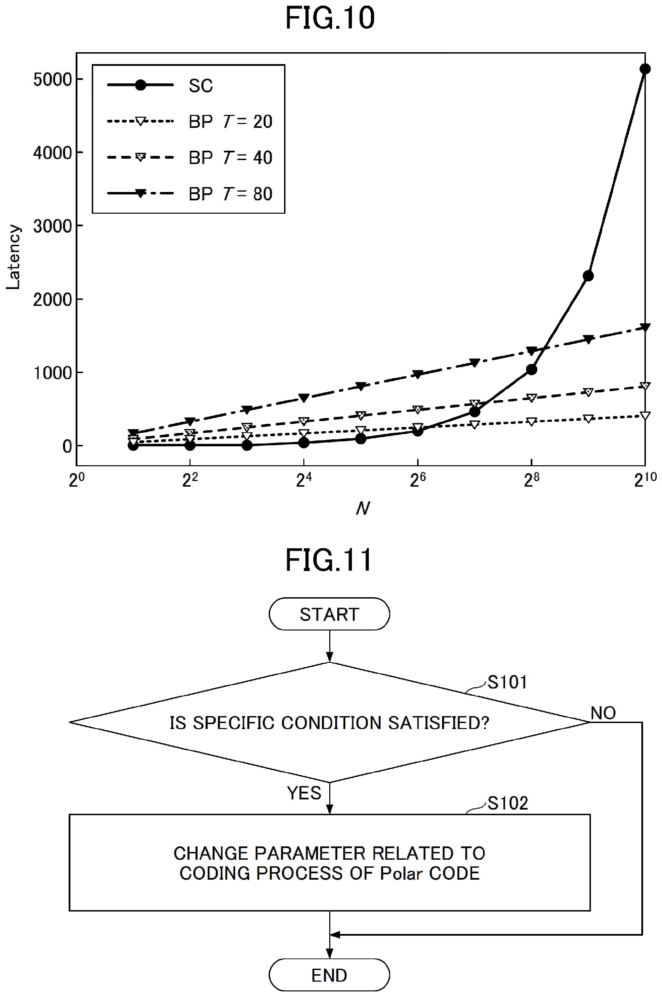

Fig. 10 is a drawing for describing processing delays of Successive Cancellation Decoding and Brief Propagation Decoding. Fig. 10 illustrates fundamental processing delays with respect to the coded word length N. As illustrated in Fig. 10, the processing delay of Brief Propagation Decoding is less than that of Successive Cancellation Decoding when the coded word length is large. In other words, Brief Propagation Decoding is suitable for decoding or a data channel whose coded word length is large.

In an example illustrated in Fig. 10, in a case where the coded word length N is equal to or greater than 2⁷, the delay of Brief Propagation Decoding with the number of iteration T being 20 is less than the delay of Successive Cancellation Decoding. It is to be noted that, with respect to Brief Propagation Decoding, the delay increases as the number of iterations T increases,

On the other hand, with respect to Brief Propagation Decoding, there are concerns that the characteristics are degraded as compared with the list type decoding and CRC (Cyclic Redundancy Check) even when the frozen bits are optimized and that, in a case where the coded word length is short, the characteristics are degraded because the likelihood is not updated due to the loop.

When applying Polar coding to a data channel, with respect to Successive Cancellation Decoding, the error correction capability asymptotically approaches the Shannon limit as the information bit sequence length increases. On the other hand, the processing delay increases in proportion with the information bit sequence length. In addition, when applying Polar coding to a data channel, with respect to Brief Propagation Decoding, the processing delay can be significantly decreased by applying the parallel processing. On the other hand, characteristics are degraded due to the change of decoding processing.

Therefore, in a case where the coded word length is short, Successive Cancellation Decoding with good characteristics is desirable to be used and, in a case where the coded word length is long, Brief Propagation Decoding with small processing delay is desirable to be used.

In addition, the error rates of each bit are different between Successive Cancellation Decoding and Brief Propagation Decoding. Therefore, the optimum frozen bit positions are different. It is to be noted that the optimum frozen bit positions corresponding to respective decoding methods can be theoretically calculated. Therefore, the frozen bit positions may be optimized in accordance with the decoding processes.

It is to be noted that, in 5G NR, Polar coding has been adopted and the frozen bit positions are specified in the technical specifications. The determination method of the frozen bit positions differs depending on the rate matching (bit selection) method. However, there is no changeability based on the configuration.

Fig. 11 is a flowchart illustrating an operation example (1) related to coding processes in an embodiment of the present invention. In step S101, the base station 10 or the terminal 20 determines whether or not a specific condition is satisfied. In a case where the specific condition is satisfied (YES in S101), the flow proceeds to step S102, and in a case where the specific condition is not satisfied (NO in S101), the flow ends. In step S102, the base station 10 or the terminal 20 changes the parameter related to the coding process of Polar codes. Subsequently, the base station 10 or the terminal 20 may transmit, to the terminal 20 or the base station 10, the coded words by performing the Polar coding by using the parameter.

When the Polar codes are used as a channel coding method, a parameter related to the coding processing may be changed according to a specific condition.

The above-described specific method may be one of the following 1) to 4), or may be a combination thereof.
1) The specific condition may be a condition specified in the technical specification. For example, a condition of performing an operation of configuring a parameter related to the coding processing based on the coded word length may be specified in the technical specification. For example, the condition may be a condition that the coded word length is greater than 2^{N} (for example, N is equal to 6), and different parameters related to the coding processing may be determined, for example, different frozen bit arrangements may be determined, depending on whether the condition is satisfied, that is, the coded word length is greater than 2^{N}, or the condition is not satisfied, that is, the coded word length is not greater than 2^{N}.
2) The specific condition may be a condition that is configured by RRC signaling. For example, a condition of performing an operation of configuring a parameter related to the coding processing based on the coded word length may be configured by RRC signaling. For example, the condition may be a condition that the coded word length is greater than 2^{N} (for example, N is equal to 6), and different parameters related to the coding processing may be determined, for example, different frozen bit arrangements may be determined, depending on whether the condition is satisfied, that is, the coded word length is greater than 2^{N}, or the condition is not satisfied, that is, the coded word length is not greater than 2^{N}.
3) The specific condition may be a condition that is indicated by MAC-CE. For example, a condition of performing an operation of configuring a parameter related to the coding processing based on the coded word length may be indicated by MAC-CE. For example, the condition may be a condition that the coded word length is greater than 2^{N} (for example, N is equal to 6), and different parameters related to the coding processing may be determined, for example, different frozen bit arrangements may be determined, depending on whether the condition is satisfied, that is, the coded word length is greater than 2^{N}, or the condition is not satisfied, that is, the coded word length is not greater than 2^{N}.
4) The specific condition may be a condition that is indicated by DCI. For example, a condition of performing an operation of configuring a parameter related to the coding processing based on the coded word length may be indicated by DCI. For example, the condition may be a condition that the coded word length is greater than 2^{N} (for example, N is equal to 6), and different parameters related to the coding processing may be determined, for example, different frozen bit arrangements may be determined, depending on whether the condition is satisfied, that is, the coded word length is greater than 2^{N}, or the condition is not satisfied, that is, the coded word length is not greater than 2^{N}.

The parameter related to the coding processing may be one of the following 1) and 2), or a combination thereof.
1) Frozen bit positions. In other words, positions of known bits that are different from information bits and are separately added at the time of coding.
2) Information bit positions.

It is to be noted that the base station 10 or the terminal 20 may configure the frozen bit positions corresponding to Brief Propagation Decoding in a case where the coded word length is either: equal to or greater than a predetermined value; or greater than a predetermined value. It is to be noted that the base station 10 or the terminal 20 may configure the frozen bit positions corresponding to Successive Cancellation Decoding in a case where the coded word length is either: equal to or less than a predetermined value; or less than a predetermined value. It is to be noted that the terminal 20 or the base station 10 on the reception side may perform reception by assuming a parameter related to the coding processing or may perform decoding by assuming the frozen bit positions that are determined according to the above-described operation.

According to the above-described operation, the coding performance can be improved by adopting the optimum frozen bit positions in accordance with the condition.

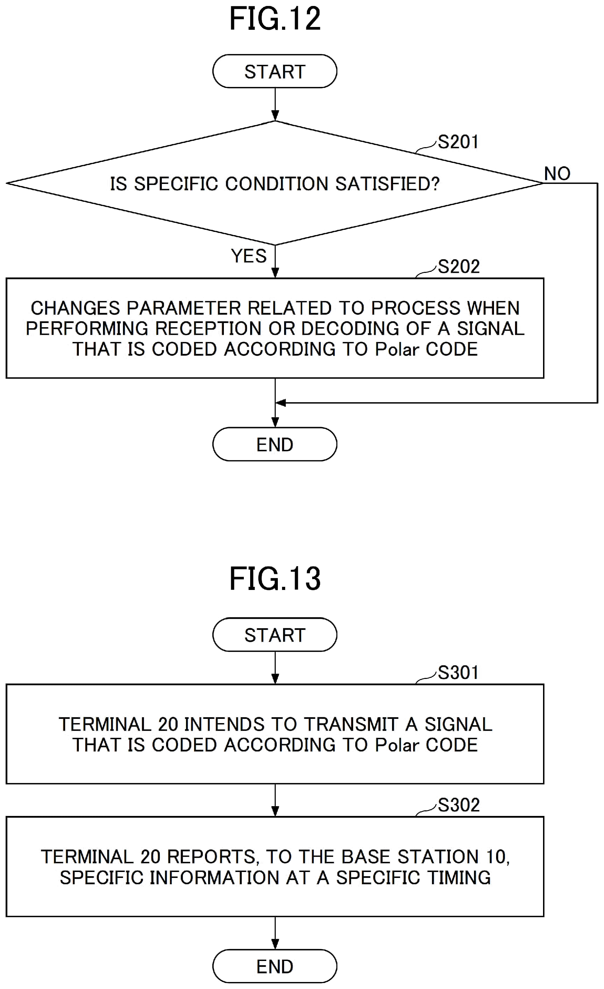

Fig. 12 is a flowchart illustrating an operation example (2) related to coding processes in an embodiment of the present invention. In step S201, the terminal 20 and the base station 10 determine whether or not a specific condition is satisfied. In a case where the specific condition is satisfied (YES in S201), the flow proceeds to step S202, and in a case where the specific condition is not satisfied (NO in S201), the flow ends. In step S202, the terminal 20 or the base station 10 changes the parameter related to the process at the time of reception of or at the time of decoding of signals that are coded by Polar codes.

When the Polar codes are used as a channel coding method, a parameter related to the processing at the time of reception or at the time of decoding may be changed according to a specific condition.

The above-described specific method may be one of the following 1) to 4), or may be a combination thereof.
1) The specific condition may be a condition specified in the technical specification. For example, a condition of performing an operation of configuring a parameter related to the processing at the time of reception or at the time of decoding, based on the allowable delay amount. For example, the condition may be a condition that the allowable delay amount is greater than a predetermined value, and different parameters related to the processing at the time of reception or at the time of decoding may be determined, depending on whether the condition is satisfied or the condition is not satisfied.
2) The specific condition may be a condition that is configured by RRC signaling. For example, a condition of performing an operation of configuring a parameter related to the processing at the time of reception or at the time of decoding, based on the allowable delay amount may be configured by RRC signaling. For example, the condition may be a condition that the allowable delay amount is greater than a predetermined value, and different parameters related to the processing at the time of reception or at the time of decoding may be determined, depending on whether the condition is satisfied or the condition is not satisfied.
3) The specific condition may be a condition that is indicated by MAC-CE. For example, a condition of performing an operation of configuring a parameter related to the processing at the time of reception or at the time of decoding, based on the allowable delay amount may be indicated by MAC-CE. For example, the condition may be a condition that the allowable delay amount is greater than a predetermined value, and different parameters related to the processing at the time of reception or at the time of decoding may be determined, depending on whether the condition is satisfied or the condition is not satisfied.
4) The specific condition may be a condition that is indicated by DCI. For example, a condition of performing an operation of configuring a parameter related to the processing at the time of reception or at the time of decoding, based on the allowable delay amount may be indicated by DCI. For example, the condition may be a condition that the allowable delay amount is greater than a predetermined value, and different parameters related to the processing at the time of reception or at the time of decoding may be determined, depending on whether the condition is satisfied or the condition is not satisfied.

The parameter related to the processing at the time of reception or at the time of decoding may be a number of iterations of a specific process. For example, the specific process may be message propagation in a case of performing Brief Propagation Decoding as a decoding method.

According to the above-described operation, the coding performance can be improved by adopting the optimum parameter in accordance with the condition.

Fig. 13 is a flowchart illustrating an operation example (3) related to coding processes in an embodiment of the present invention. In step S301, the terminal 20 intends to transmit a signal that is coded by Polar codes. In step S302, the terminal 20 reports specific information to the base station 10 at a specific timing.

The specific timing in step S302 may be one of the following 1) and 2) or may be a combination thereof.
1) The specific timing may be the same timing as the transmission. For example, the specific information may be multiplexed with the PUSCH and/or PUCCH coded by Polar codes.
2) The specific timing may be a timing before the transmission. The timing before the transmission may be specified by the technical specification, may be configured by RRC signaling from the base station 10, or may be indicated by MAC-CE and/or DCI from the base station 10. The timing before the transmission that is specified, configured, or indicated may be, for example, before X milliseconds, before X slots, before X OFDM symbols, or the like.

The specific information in step S302 may be one of the following 1) to 4) or may be a combination thereof.
1) Frozen bit positions.
2) Index indicating the frozen bit positions.
3) Information bit positions.
4) Index indicating the information bit positions.

According to the above-described operation, the necessary information can be indicated to the base station 10 at an appropriate timing when the terminal 20 performs transmission of a signal that is coded by Polar codes.

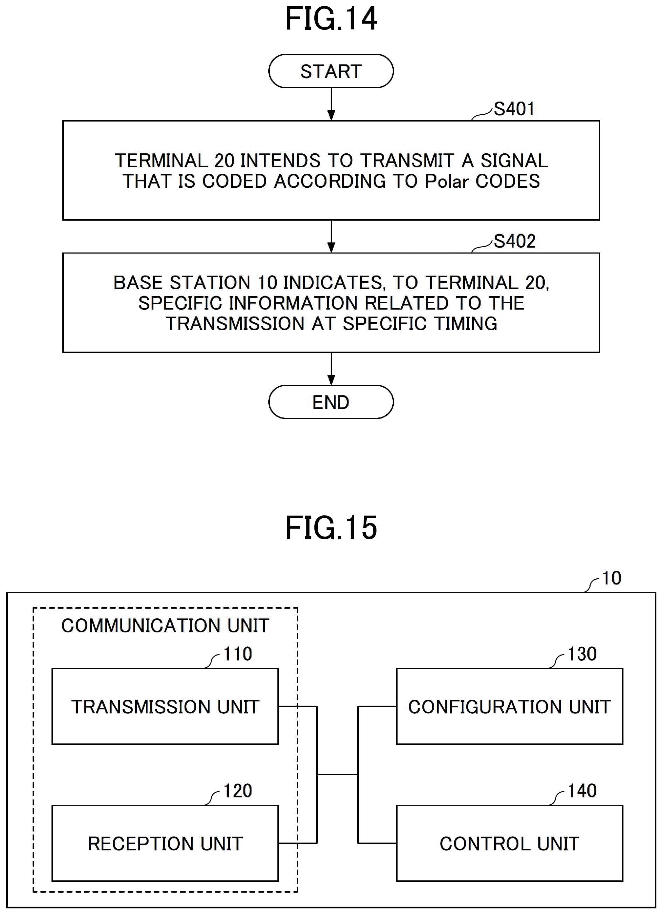

Fig. 14 is a flowchart illustrating an operation example (4) related to coding processes in an embodiment of the present invention. In step S401, the terminal 20 intends to transmit a signal that is coded by Polar codes. In step S402, the base station 10 indicates, to the terminal 20, specific information at a specific timing.

The specific timing in step S402 may be a timing before the transmission. The timing before the transmission may be specified by the technical specification, may be configured by RRC signaling from the base station 10, or may be indicated by MAC-CE and/or DCI from the base station 10. The timing before the transmission that is specified, configured, or indicated may be, for example, before X milliseconds, before X slots, before X OFDM symbols, or the like.

The specific information in step S402 may be one of the following 1) to 5) or may be a combination thereof.
1) Information indicating the decoding method supported by the base station 10. The information may be Successive Cancellation Decoding, may be Brief Propagation Decoding, or may be Successive Cancellation Decoding and Brief Propagation Decoding.
2) Frozen bit positions.
3) Index indicating the frozen bit positions.
4) Information bit positions.
5) Index indicating the information bit positions.

In a case where the configuration or the indication of the specific information is not received by the terminal 20, the terminal 20 may perform an operation as described in the following 1) and/or 2).
1) Default information (for example, default frozen bit positions) is defined in the technical specification and the terminal 20 performs an operation based on the default information.
2) A plurality of default information items (for example, default frozen bit positions) are defined in the technical specification and the terminal 20 determines which one of the plurality of information items is to be used.

According to the above-described operation, the necessary information can be obtained from the base station 10 at an appropriate timing when the terminal 20 performs transmission of a signal that is coded by Polar codes.

It is to be noted that the frozen bit may be replaced with "a known bit (0 or 1) that is added when encoding an information bit based on Polar codes".

It is to be noted that a part of or all of the embodiments may be performed only in a case where a specific RRC parameter is configured. The specific RRC parameter may indicate activation or deactivation of a control function of frozen bit positions in Polar codes, may indicate activation or deactivation of a reporting function of assistance information related to frozen bit positions from the terminal 20, or may indicate activation or deactivation of a reporting function of assistance information related to decoding method of Polar codes at the base station 10.

It is to be noted that an embodiment of the present invention may be defined as an essential function (for example, a mandatory function that does not require reporting of UE capability) in the technical specification related to 6G, for example, a RAT that is different from 5G-NR and will be deployed in Release 20 or after Release 20, or may be defined as an optional function (for example, an optional function that requires reporting of UE capability) in 5G-NR and/or 6G. In a case of being defined as an optional function, the UE capability signaling for reporting whether or not to support an embodiment of the present invention may be defined.

According to an embodiment of the present invention, the terminal 20 can adaptively apply an appropriate coding method to a physical channel depending on the communication condition.

In other words, characteristics of the Polar coding method can be improved in the wireless communication system.

### (Device configuration)

Next, a functional configuration example of the base station 10 and the terminal 20 for performing the processes and operations described above will be described. The base station 10 and the terminal 20 include functions for implementing the embodiments described above. It should be noted, however, that each of the base stations 10 and the terminal 20 may include only some of the functions in an embodiment.

### <Base station 10>

Fig. 15 is a drawing illustrating an example of a functional structure of a base station 10 according to an embodiment of the present invention. As shown in Fig. 15, the base station 10 includes a transmission unit 110, a reception unit 120, a configuration unit 130, and a control unit 140. The functional configuration illustrated in Fig. 15 is merely an example. Functional divisions and names of functional units may be anything as long as operations according to an embodiment of the present invention can be performed.

The transmission unit 110 includes a function for generating a signal to be transmitted to the terminal 20 side and transmitting the signal wirelessly. Further, the transmission unit 110 transmits an inter-network-node message to another network node. The reception unit 120 includes a function for receiving various signals transmitted from the terminal 20 and acquiring, for example, information of a higher layer from the received signals. In addition, the transmission unit 110 has a function of transmitting NR-PSS, NR-SSS, NR-PBCH, DL/UL control signals, and the like to the terminal 20. Further, the reception unit 120 receives an inter-network-node message from another network node.

The configuration unit 130 stores preset information and various configuration information items to be transmitted to the terminal 20. Contents of the configuration information are, for example, information related to the configuration of the encoding method.

The control unit 140 performs control related to the configuration of the encoding method as described in an embodiment of the present invention. In addition, the control unit 140 performs scheduling. The functional units related to signal transmission in the control unit 140 may be included in the transmission unit 110, and the functional units related to signal reception in the control unit 140 may be included in the reception unit 120.

### <Terminal 20>

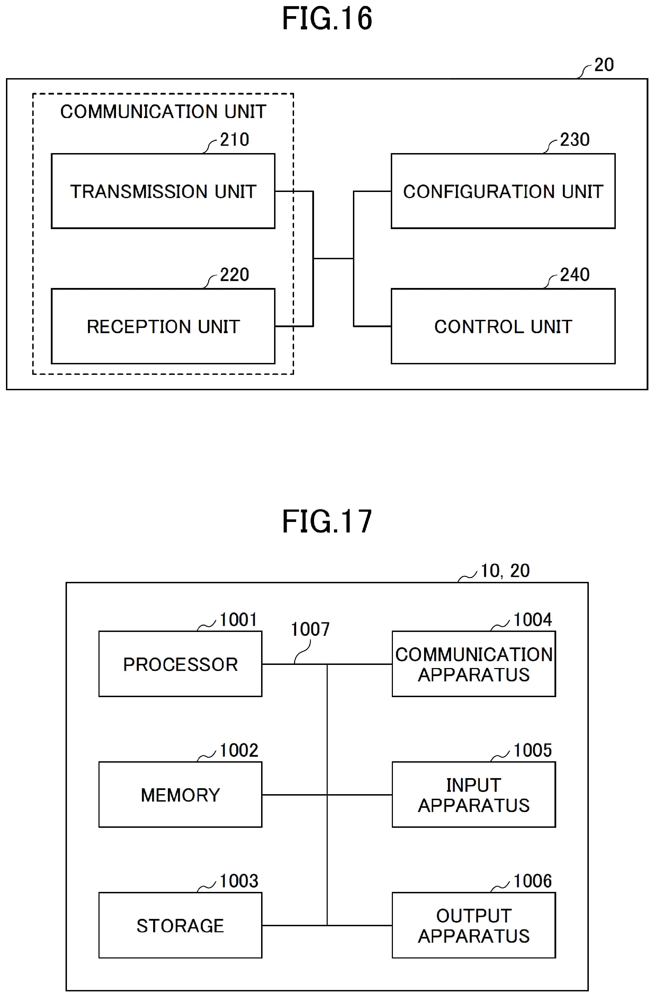

Fig. 16 is a drawing illustrating an example of a functional structure of a terminal 20 according to an embodiment of the present invention. As shown in Fig. 16, the terminal 20 includes a transmission unit 210, a reception unit 220, a configuration unit 230, and a control unit 240. The functional configuration illustrated in Fig. 16 is merely an example. Functional divisions and names of functional units may be anything as long as operations according to an embodiment of the present invention can be performed.

The transmission unit 210 generates a transmission signal from transmission data and transmits the transmission signal wirelessly. The reception unit 220 receives various signals wirelessly and obtains higher layer signals from the received physical layer signals. In addition, the reception unit 220 has a function of receiving NR-PSS, NR-SSS, NR-PBCH, DL/UL/SL control signals, and the like, transmitted from the base station 10. In addition, for example, with respect to the D2D communications, the transmission unit 210 transmits, to another terminal 20, PSCCH (Physical Sidelink Control Channel), PSSCH (Physical Sidelink Shared Channel), PSDCH (Physical Sidelink Discovery Channel), PSBCH (Physical Sidelink Broadcast Channel), etc., and the reception unit 220 receives, from the another terminal 20, PSCCH, PSSCH, PSDCH, PSBCH, etc.

The configuration unit 230 stores various configuration information items received by the reception unit 220 from the base station 10. In addition, the configuration unit 230 also stores pre-configured configuration information. Contents of the configuration information are, for example, information related to the configuration of the encoding method.

The control unit 240 performs control related to the configuration of the encoding method as described in an embodiment of the present invention. The functional units related to signal transmission in the control unit 240 may be included in the transmission unit 210, and the functional units related to signal reception in the control unit 240 may be included in the reception unit 220.

### (Hardware structure)

The block diagrams that have been used to describe the above embodiments (Fig. 15 and Fig. 16) show blocks in functional units. These functional blocks (components) may be implemented in arbitrary combinations of at least one of hardware or software. Also, the method for implementing each functional block is not particularly limited. That is, each functional block may be realized by one piece of apparatus that is physically or logically coupled, or may be realized by directly or indirectly connecting two or more physically or logically separate pieces of apparatus (for example, via wire, wireless, or the like) and using these plurality of pieces of apparatus. The functional blocks may be implemented by combining software into the apparatus described above or the plurality of apparatuses described above.

Functions include judgment, determination, decision, calculation, computation, processing, derivation, investigation, search, confirmation, reception, transmission, output, access, resolution, selection, designation, establishment, comparison, assumption, expectation, considering, broadcasting, notifying, communicating, forwarding, configuring, reconfiguring, allocating (mapping), assigning, and the like, but function are by no means limited to these. For example, the functional block (component) to implement a function of transmission may be referred to as a transmitting unit or a transmitter. The method for implementing each component is not particularly limited as described above.

For example, the base station 10, the terminal 20, etc., according to an embodiment of the present disclosure may function as a computer for processing the radio communication method of the present disclosure. Fig. 17 is a diagram to show an example of a hardware structure of the base station 10 and the terminal 20 according to one embodiment. Physically, the above-described base station 10 and terminal 20 may each be formed as a computer apparatus that includes a processor 1001, a memory 1002, a storage 1003, a communication apparatus 1004, an input apparatus 1005, an output apparatus 1006, a bus 1007, and so on.

Note that in the present disclosure, the words such as an apparatus, a circuit, a device, a section, a unit, and so on can be interchangeably interpreted. The hardware structure of the base station 10 and the terminal 20 may be configured to include one or more of apparatuses shown in the drawings, or may be configured not to include part of apparatuses.

Each function of the base station 10 and the terminals 20 is implemented, for example, by allowing certain software (programs) to be read on hardware such as the processor 1001 and the memory 1002, and by allowing the processor 1001 to perform calculations to control communication via the communication apparatus 1004 and control at least one of reading or writing of data in the memory 1002 and the storage 1003.

The processor 1001 controls the whole computer by, for example, running an operating system. The processor 1001 may be configured with a central processing unit (CPU), which includes interfaces with peripheral apparatus, control apparatus, computing apparatus, a register, and so on. For example, the above-described control unit 140, control unit 240, and so on may be implemented by the processor 1001.

Furthermore, the processor 1001 reads programs (program codes), software modules, data, or the like, from at least one of the storage 1003 and the communication apparatus 1004, into the memory 1002, and executes various processes according to these. As for the programs, programs to allow computers to execute at least part of the operations of the above-described embodiments are used. For example, the control unit 140 of the base station 10 illustrated in Fig. 15 may be implemented by control programs that are stored in the memory 1002 and that operate on the processor 1001. In addition, for example, the control unit 240 of the terminal 20 illustrated in Fig. 16 may be implemented by control programs that are stored in the memory 1002 and that operate on the processor 1001. The various processes have been described to be performed by a single processor 1001. However, the processes may be performed by two or more processors 1001 simultaneously or sequentially. The processor 1001 may be implemented by one or more chips. It should be noted that the program may be transmitted from a network via a telecommunication line.

The memory 1002 is a computer-readable recording medium, and may be constituted with, for example, at least one of a Read Only Memory (ROM), an Erasable Programmable ROM (EPROM), an Electrically Erasable Programmable ROM (EEPROM), a Random Access Memory (RAM), or other appropriate storage media. The memory 1002 may be referred to as a "register," a "cache," a "main memory (primary storage apparatus)" and so on. The memory 1002 can store executable programs (program codes), software modules, and the like for implementing the communication method according to one embodiment of the present disclosure.

The storage 1003 is a computer-readable recording medium, and may be constituted with, for example, at least one of a flexible disk, a floppy (registered trademark) disk, a magneto-optical disk (for example, a compact disc (Compact Disc ROM (CD-ROM) and so on), a digital versatile disc, a Blu-ray (registered trademark) disk), a removable disk, a hard disk drive, a smart card, a flash memory device (for example, a card, a stick, and a key drive), a magnetic stripe, a database, a server, or other appropriate storage media. The above recording medium may be a database including the memory 1002 and/or the storage 1003, a server, or any other appropriate medium.

The communication apparatus 1004 is hardware (transmitting/receiving device) for allowing inter-computer communication via at least one of wired or wireless networks, and may be referred to as, for example, a "network device," a "network controller," a "network card," a "communication module," and so on. The communication apparatus 1004 may be configured to include a high frequency switch, a duplexer, a filter, a frequency synthesizer, and so on in order to realize, for example, at least one of frequency division duplex (FDD) or time division duplex (TDD). For example, the transmitting/receiving antenna, the amplifier unit, the transmitting/receiving unit, the transmission line interface, and the like, may be implemented by the communication apparatus 1004. The transmitting/receiving unit may be physically or logically divided into a transmitting unit and a receiving unit.

The input apparatus 1005 is an input device that receives input from the outside (for example, a keyboard, a mouse, a microphone, a switch, a button, a sensor, and so on). The output apparatus 1006 is an output device that outputs something to the outside (for example, a display, a speaker, an LED lamp). Note that the input apparatus 1005 and the output apparatus 1006 may be provided in an integrated structure (for example, a touch panel).

Furthermore, these types of apparatus, including the processor 1001, the memory 1002, and others, are connected by a bus 1007 for communicating information. The bus 1007 may be formed with a single bus, or may be formed with buses that vary between pieces of apparatus.

Also, the base station 10 and the terminals 20 may be structured to include hardware such as a microprocessor, a digital signal processor (DSP), an Application Specific Integrated Circuit (ASIC), a Programmable Logic Device (PLD), a Field Programmable Gate Array (FPGA), and so on, and part or all of the functional blocks may be implemented by the hardware. Also, the base station 10 and the terminals 20 may be structured to include hardware such as a microprocessor, a digital signal processor (DSP), an Application Specific Integrated Circuit (ASIC), a Programmable Logic Device (PLD), a Field Programmable Gate Array (FPGA), and so on, and part or all of the functional blocks may be implemented by the hardware. For example, the processor 1001 may be implemented with at least one of these pieces of hardware.

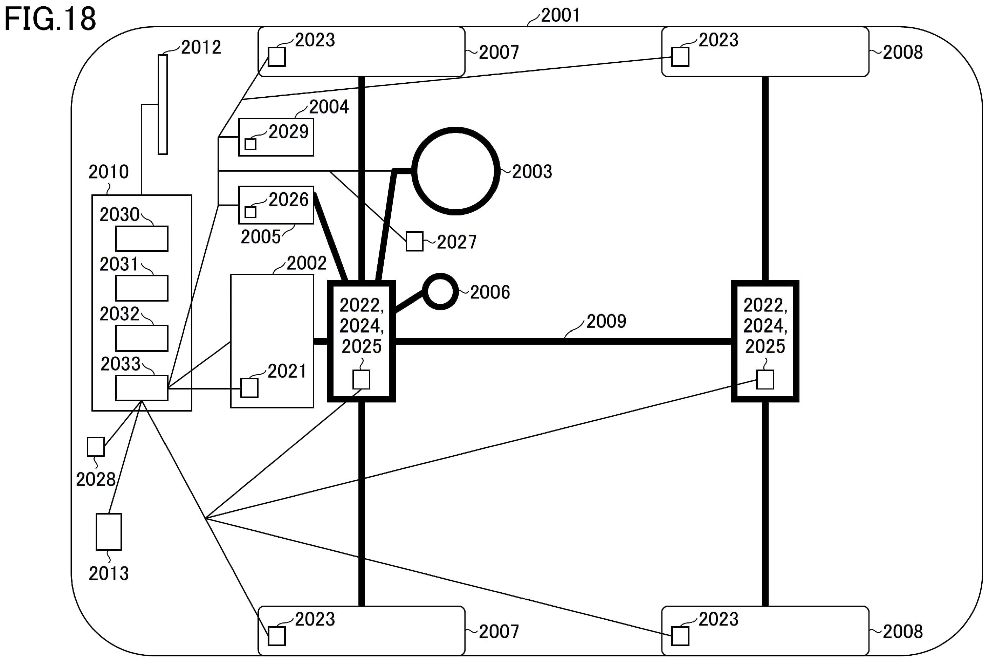

Fig. 18 shows an example of a configuration of a vehicle 2001. As shown in Fig. 18, the vehicle 2001 includes a drive unit 2002, a steering unit 2003, an accelerator pedal 2004, a brake pedal 2005, a shift lever 2006, a front wheel 2007, a rear wheel 2008, an axle 2009, an electronic control unit 2010, various sensors 2021-2029, an information service unit 2012, and a communication module 2013. The aspects/embodiments described in the present disclosure may be applied to a communication device mounted in the vehicle 2001, and may be applied to, for example, the communication module 2013.

The drive unit 2002 may include, for example, an engine, a motor, and a hybrid of an engine and a motor. The steering unit 2003 includes at least a steering wheel and is configured to steer at least one of the front wheels or the rear wheels, based on the operation of the steering wheel operated by the user.

The electronic control unit 2010 includes a microprocessor 2031, a memory (ROM, RAM) 2032, and a communication port (IO port) 2033. The electronic control unit 2010 receives signals from the various sensors 2021-2029 provided in the vehicle 2001. The electronic control unit 2010 may be referred to as an ECU (Electronic control unit).

The signals from the various sensors 2021 to 2029 include a current signal from a current sensor 2021 that senses the current of the motor, a front or rear wheel rotation signal acquired by a revolution sensor 2022, a front or rear wheel pneumatic signal acquired by a pneumatic sensor 2023, a vehicle speed signal acquired by a vehicle speed sensor 2024, an acceleration signal acquired by an acceleration sensor 2025, a stepped-on accelerator pedal signal acquired by an accelerator pedal sensor 2029, a stepped-on brake pedal signal acquired by a brake pedal sensor 2026, an operation signal of a shift lever acquired by a shift lever sensor 2027, and a detection signal, acquired by an object detection sensor 2028, for detecting an obstacle, a vehicle, a pedestrian, and the like.

The information service unit 2012 includes various devices for providing (outputting) various kinds of information such as driving information, traffic information, and entertainment information, including a car navigation system, an audio system, a speaker, a television, and a radio, and one or more ECUs controlling these devices. The information service unit 2012 provides various types of multimedia information and multimedia services to the occupants of the vehicle 2001 by using information obtained from the external device through the communication module 2013 or the like. The information service unit 2012 may include an input device (for example, a keyboard, a mouse, a microphone, a switch, a button, a sensor, a touch panel, and the like) for receiving input from the outside, or may include an output device (for example, a display, a speaker, an LED lamp, a touch panel, and the like) for implementing output to the outside.

A driving support system unit 2030 includes: various devices for providing functions of preventing accidents and reducing driver's operating loads such as a millimeter wave radar, a LiDAR (Light Detection and Ranging), a camera, a positioning locator (e.g., GNSS, etc.), map information (e.g., high definition (HD) map, autonomous vehicle (AV) map, etc.), a gyro system (e.g., IMU (Inertial Measurement Unit), INS (Inertial Navigation System), etc.), an AI (Artificial Intelligence) chip, an AI processor; and one or more ECUs controlling these devices. In addition, the driving support system unit 2030 transmits and receives various types of information via the communication module 2013 to realize a driving support function or an autonomous driving function.

The communication module 2013 can communicate with the microprocessor 2031 and components of the vehicle 2001 via a communication port. For example, the communication module 2013 transmits and receives data via a communication port 2033, to and from a drive unit 2002, a steering unit 2003, an accelerator pedal 2004, a brake pedal 2005, a shift lever 2006, front wheels 2007, rear wheels 2008, an axle 2009, a microprocessor 2031 and a memory (ROM, RAM) 2032 in the electronic control unit 2010, and sensors 2021 to 2029 provided in the vehicle 2001.

The communication module 2013 is a communication device that can be controlled by the microprocessor 2031 of the electronic control unit 2010 and that is capable of communicating with external devices. For example, various kinds of information are transmitted to and received from external devices through radio communication. The communication module 2013 may be internal to or external to the electronic control unit 2010. The external devices may include, for example, a base station, a mobile station, or the like.

The communication module 2013 may transmit at least one of signals from the various sensors 2021 to 2028 described above input to the electronic control unit 2010, information obtained based on the signals, and information based on an input from the outside (a user) obtained via the information service unit 2012, to the external apparatus via radio communication. The electronic control unit 2010, the various sensors 2021 to 2028, the information service unit 2012, and the like may be referred to as input units that receive input. For example, the PUSCH transmitted by the communication module 2013 may include information based on the input.

The communication module 2013 receives various types of information (traffic information, signal information, inter-vehicle information, etc.) transmitted from the external devices and displays the received information on the information service unit 2012 provided in the vehicle 2001. The information service unit 2012 may be referred to as an output unit that outputs information (for example, outputs information to devices, such as a display, a speaker, or the like, based on the PDSCH received by the communication module 2013 (or data/information decoded from the PDSCH)). In addition, the communication module 2013 stores the various types of information received from the external devices in the memory 2032 available to the microprocessor 2031. Based on the information stored in the memory 2032, the microprocessor 2031 may control the drive unit 2002, the steering unit 2003, the accelerator pedal 2004, the brake pedal 2005, the shift lever 2006, the front wheel 2007, the rear wheel 2008, the axle 2009, the sensors 2021-2029, etc., mounted in the vehicle 2001.

### (Embodiment summary)

As described above, according to an embodiment of the present invention, a communication device is provided. The communication device includes: a control unit configured to perform coding of information bits by using Polar codes; and a transmission unit configured to transmit coded words corresponding to the information bits to another communication device. The control unit determines positions of known bits that are added at a time of the coding of the information bits, based on a specific condition.

According to the above-described configuration, the terminal 20 can adaptively apply an appropriate coding method to a physical channel depending on the communication condition. In other words, characteristics of the Polar coding method can be improved in the wireless communication system.

The control unit may determine the positions of the known bits, based on a length of the coded words.
According to the above-described configuration, the terminal 20 can adaptively apply an appropriate coding method to a physical channel depending on the communication condition.

The control unit may determine the positions of the known bits corresponding to Brief Propagation Decoding in a case where a length of the coded words is greater than a certain value. According to the above-described configuration, the terminal 20 can adaptively apply an appropriate coding method to a physical channel depending on the communication condition.

The control unit may determine the positions of the known bits corresponding to Successive Cancellation Decoding in a case where a length of the coded words is not greater than a certain value. According to the above-described configuration, the terminal 20 can adaptively apply an appropriate coding method to a physical channel depending on the communication condition.

The communication device further includes: a reception unit configured to receive coded words that are coded by Polar codes, and the control unit may determine a number of iterations in Brief Propagation Decoding applied to the received coded words, based on a specific condition. According to the above-described configuration, the terminal 20 can adaptively apply an appropriate coding method to a physical channel depending on the communication condition.

In addition, according to an embodiment of the present invention, a communication method performed by a communication device is provided. The communication method includes: performing coding of information bits by using Polar codes; transmitting coded words corresponding to the information bits to another communication device; and determining positions of known bits that are added at a time of the coding of the information bits, based on a specific condition.

According to the above-described configuration, the terminal 20 can adaptively apply an appropriate coding method to a physical channel depending on the communication condition. In other words, characteristics of the Polar coding method can be improved in the wireless communication system.

### (Supplement of embodiment)

As described above, one or more embodiments have been described. The present invention is not limited to the above embodiments. A person skilled in the art should understand that there are various modifications, variations, alternatives, replacements, etc., of the embodiments. In order to facilitate understanding of the present invention, specific values have been used in the description. However, unless otherwise specified, those values are merely examples and other appropriate values may be used. The division of the described items may not be essential to the present invention. The things that have been described in two or more items may be used in a combination if necessary, and the thing that has been described in one item may be appropriately applied to another item (as long as there is no contradiction). Boundaries of functional units or processing units in the functional block diagrams do not necessarily correspond to the boundaries of physical parts. Operations of multiple functional units may be physically performed by a single part, or an operation of a single functional unit may be physically performed by multiple parts. The order of sequences and flowcharts described related to an embodiment of the present invention may be changed as long as there is no contradiction. For the sake of description convenience, the base station 10 and the terminal 20 have been described by using functional block diagrams. However, the apparatuses may be realized by hardware, software, or a combination of hardware and software. The software executed by a processor included in the base station 10 according to an embodiment of the present invention and the software executed by a processor included in the terminal 20 according to an embodiment of the present invention may each be stored in a random access memory (RAM), a flash memory, a read only memory (ROM), an EPROM, an EEPROM, a register, a hard disk (HDD), a removable disk, a CD-ROM, a database, a server, or any other appropriate recording medium.

In addition, notification of information is by no means limited to the aspects/embodiments described in the present disclosure, and other methods may be used as well. For example, notification of information may be implemented by using physical layer signaling (for example, downlink control information (DCI), uplink control information (UCI)), higher layer signaling (for example, radio resource control (RRC) signaling, medium access control (MAC) signaling), broadcast information (master information block (MIB), system information block (SIB)), and other signals or combinations thereof. Also, RRC signaling may be referred to as an "RRC message," and can be, for example, an RRC connection setup message, an RRC connection reconfiguration message, and so on.

Each aspect/embodiment described in the present disclosure may be applied to at least one of a system using LTE (Long Term Evolution), LTE-A (LTE-Advanced), SUPER 3G, IMT-Advanced, 4G (4th generation mobile communication system), 5G (5th generation mobile communication system), FRA (Future Radio Access), NR (new Radio), W-CDMA (registered trademark), GSM (registered trademark), CDMA2000, UMB (Ultra Mobile Broadband), IEEE 802.11 (Wi-Fi (registered trademark)), IEEE 802.16 (WiMAX (registered trademark)), IEEE 802.20, UWB (Ultra-WideBand), Bluetooth (registered trademark), and other appropriate systems, or a next generation system enhanced therefrom. In addition, a plurality of systems may be combined (for example, a combination of: at least one of LTE or LTE-A; 5G, and the like) to be applied.

The order of processes, sequences, flowcharts, and so on that have been used to describe the aspects/embodiments in the present specification may be re-ordered as long as inconsistencies do not arise. For example, although various methods have been illustrated in the present disclosure with various components of steps in exemplary orders, the specific orders that are illustrated herein are by no means limiting.

Operations which have been described in the present specification to be performed by a base station 10 may, in some cases, be performed by an upper node of the base station 10. In a network including one or a plurality of network nodes with base stations 10, it is clear that various operations that are performed to communicate with terminals 20 can be performed by base stations 10, one or more network nodes (for example, Mobility Management Entities (MMEs), Serving-Gateways (S-GWs), and so on may be possible, but these are not limiting) other than base stations 10, or combinations of these. According to the above, a case is described in which there is a single network node other than the base station 10. However, a combination of multiple other network nodes may be considered (e.g., MME and S-GW).

The information or signals described in this disclosure may be output from a higher layer (or lower layer) to a lower layer (or higher layer). The information or signals may be input or output through multiple network nodes.

The input or output information may be stored in a specific location (e.g., memory) or managed using management tables. The input or output information may be overwritten, updated, or added. The information that has been output may be deleted. The information that has been input may be transmitted to another apparatus.

A decision or a determination in the present disclosure may be implemented by a value (0 or 1) represented by one bit, by a Boolean value (true or false), or by comparison of numerical values (e.g., comparison with a predetermined value).

Software should be broadly interpreted to mean, whether referred to as software, firmware, middle-ware, microcode, hardware description language, or any other name, instructions, instruction sets, codes, code segments, program codes, programs, subprograms, software modules, applications, software applications, software packages, routines, subroutines, objects, executable files, executable threads, procedures, functions, and the like.

Further, software, instructions, information, and the like may be transmitted and received via a transmission medium. For example, in the case where software is transmitted from a website, server, or other remote source using at least one of wired line technologies (such as coaxial cable, fiber optic cable, twisted pair, digital subscriber line (DSL), etc.) or wireless technologies (infrared, microwave, etc.), at least one of these wired line technologies or wireless technologies is included within the definition of the transmission medium.

Information, a signal, or the like, described in the present specification may be represented by using any one of various different technologies. For example, data, an instruction, a command, information, a signal, a bit, a symbol, a chip, or the like, described throughout the present application, may be represented by a voltage, an electric current, electromagnetic waves, magnetic fields, a magnetic particle, optical fields, a photon, or a combination thereof.

It should be noted that a term used in the present specification and/or a term required for understanding of the present specification may be replaced by a term having the same or similar meaning. For example, a channel and/or a symbol may be a signal (signaling). Further, a signal may be a message. Further, the component carrier (CC) may be referred to as a carrier frequency, cell, frequency carrier, or the like.

As used in the present disclosure, the terms "system" and "network" are used interchangeably.

Further, the information, parameters, and the like, described in the present disclosure may be expressed using absolute values, relative values from predetermined values, or they may be expressed using corresponding different information. For example, a radio resource may be what is indicated by an index.

The names used for the parameters described above are not used as limitations. Further, the mathematical equations using these parameters may differ from those explicitly disclosed in the present disclosure. Because various channels (e.g., PUCCH, PDCCH, or the like) and information elements may be identified by any suitable names, the various names assigned to these various channels and information elements are not used as limitations.

In the present disclosure, the terms "Base Station (BS)", "Radio Base Station", "Base Station Apparatus", "Fixed Station", "NodeB", "eNodeB (eNB)", "gNodeB (gNB)", "Access Point", "Transmission Point", "Reception Point", "Transmission/Reception Point", "Cell", "Sector", "Cell Group", "Carrier", "Component Carrier", and the like, may be used interchangeably. The base station may be referred to as the terms such as a "macro cell," a "small cell," a "femto cell," a "pico cell," and so on.

A base station can accommodate one or a plurality of (for example, three) cells. When a base station supports a plurality of cells, the entire coverage area of the base station can be partitioned into multiple smaller areas, and each smaller area can provide communication services through base station subsystems (for example, indoor small base stations (Remote Radio Heads (RRHs))). The term "cell" or "sector" refers to part of or the entire coverage area of at least one of a base station or a base station subsystem that provides communication services within this coverage.

In the present disclosure, transmitting information to the terminal by the base station may be referred to as instructing the terminal to perform any control and/or operation based on the information by the base station.

In the present disclosure, terms such as "mobile station (MS)", "user terminal", "user equipment (UE)", "terminal", and the like, may be used interchangeably.

A mobile station may be referred to as a "subscriber station," "mobile unit," "subscriber unit," "wireless unit," "remote unit," "mobile device," "wireless device," "wireless communication device," "remote device," "mobile subscriber station," "access terminal," "mobile terminal," "wireless terminal," "remote terminal," "handset," "user agent," "mobile client," "client," or some other appropriate terms in some cases.

At least one of a base station or a mobile station may be referred to as a "transmitting apparatus," a "receiving apparatus," a "radio communication apparatus," and so on. Note that at least one of a base station or a mobile station may be a device mounted on a moving object or a moving object itself, and so on. The mobile station is an object that can move, and the moving speed can be any speed. In addition, a mobile station that is not moving is also included. Examples of the moving object include, but are not limited to, a vehicle, a transport vehicle, an automobile, a motorcycle, a bicycle, a connected car, a loading shovel, a bulldozer, a wheel loader, a dump truck, a fork lift, a train, a bus, a trolley, a rickshaw, a ship and other watercraft, an airplane, a rocket, a satellite, a drone (registered trademark), a multicopter, a quadcopter, a balloon, and an object mounted on any of these. The moving object may be a moving object that autonomously travels based on a direction for moving. The moving object may be a vehicle (for example, a car, an airplane, and the like), may be a moving object which moves unmanned (for example, a drone, an automatic operation car, and the like), or may be a robot (a manned type or unmanned type). Note that at least one of a base station or a mobile station also includes an apparatus which does not necessarily move during communication operation. For example, at least one of the base station or the mobile station may be an IoT (Internet of Things) device such as a sensor.

Furthermore, the base station in the present disclosure may be interpreted as a user terminal. For example, each aspect/embodiment of the present disclosure may be applied to the structure in which communications between a base station and a user terminal is replaced with communications between a plurality of terminals 20 (for example, which may be referred to as Device-to-Device (D2D), Vehicle-to-Everything (V2X), and the like). In this case, terminals 20 may have the functions of the base stations 10 described above. The words such as "uplink" and "downlink" may be interpreted as the words corresponding to the terminal-to-terminal communication (for example, "sidelink"). For example, an uplink channel, a downlink channel and so on may be interpreted as a sidelink channel.

Likewise, the user terminal in the present disclosure may be interpreted as base station. In this case, the base station may have the functions of the user terminal described above.

As used herein, the term "determining" may encompass a wide variety of actions. For example, "determining" may be regarded as judging, calculating, computing, processing, deriving, investigating, looking up (search, inquiry) (e.g., looking up in a table, a database or another data structure), ascertaining and the like. Also, "determining" may be regarded as receiving (e.g., receiving information), transmitting (e.g., transmitting information), inputting, outputting, accessing (e.g., accessing data in a memory) and the like. Also, "determining" may be regarded as resolving, selecting, choosing, establishing, comparing, and the like. That is, "determining" may be regarded as a certain type of action related to determining. Further, "decision" may be read as "assuming", "expecting", or "considering", etc.

The term "connected" or "coupled" or any variation thereof means any direct or indirect connection or connection between two or more elements and may include the presence of one or more intermediate elements between the two elements "connected" or "coupled" with each other. The coupling or connection between the elements may be physical, logical, or a combination thereof. For example, "connection" may be read as "access". As used in the present disclosure, the two elements may be thought of as being "connected" or "coupled" to each other using at least one of the one or more wires, cables, or printed electrical connections and, as a number of non-limiting and non-inclusive examples, electromagnetic energy having wavelengths in the radio frequency region, the microwave region, and the light (both visible and invisible) region.

A reference signal may be abbreviated as an "RS," and may be referred to as a "pilot," and so on, depending on which standard applies.

The phrase "based on" (or "on the basis of") as used in the present disclosure does not mean "based only on" (or "only on the basis of"), unless otherwise specified. In other words, the phrase "based on" (or "on the basis of") means both "based only on" and "based at least on" ("only on the basis of" and "at least on the basis of").

Reference to elements with designations such as "first," "second," and so on as used in the present disclosure does not generally limit the quantity or order of these elements. These designations may be used in the present disclosure only for convenience, as a method for distinguishing between two or more elements. Thus, reference to the first and second elements does not imply that only two elements may be employed, or that the first element must precede the second element in some way.

"Means" included in the configuration of each of the above apparatuses may be replaced by "parts", "circuits", "devices", etc.

In the case where the terms "include", "including" and variations thereof are used in the present disclosure, these terms are intended to be comprehensive in the same way as the term "comprising". Further, the term "or" used in the present specification is not intended to be an "exclusive or".

A radio frame may be constituted of one or a plurality of periods (frames) in the time domain. Each of one or a plurality of periods (frames) constituting a radio frame may be referred to as a "subframe." Furthermore, a subframe may be constituted of one or a plurality of slots in the time domain. A subframe may have a fixed time length (for example, 1 ms) that does not depend on the numerology.

Numerology may be a communication parameter applied to at least one of transmission or reception of a certain signal or channel. The numerology may indicate at least one of, for example, subcarrier spacing (SCS), bandwidth, symbol length, cyclic prefix length, transmission time interval (TTI), number of symbols per TTI, radio frame configuration, specific filtering processing performed by the transceiver in the frequency domain, and specific windowing processing performed by the transceiver in the time domain.

The slot may include one or more symbols in the time domain (OFDM (Orthogonal Frequency Division Multiplexing) symbols, SC-FDMA (Single Carrier Frequency Division Multiple Access) symbols, and the like). Furthermore, a slot may be a time unit based on numerology.

A slot may include a plurality of mini-slots. Each mini-slot may be constituted of one or a plurality of symbols in the time domain. A mini-slot may be referred to as a "sub-slot." A mini-slot may be constituted of symbols less than the number of slots. A PDSCH (or PUSCH) transmitted in a time unit larger than a mini-slot may be referred to as PDSCH (or PUSCH) mapping type A. A PDSCH (or PUSCH) transmitted using a mini-slot may be referred to as PDSCH (or PUSCH) mapping type B.

A radio frame, a subframe, a slot, a mini-slot, and a symbol all express time units in signal communication. A radio frame, a subframe, a slot, a mini-slot, and a symbol may each be called by other applicable terms.

For example, one subframe may be referred to as a transmission time interval, "TTI," a plurality of consecutive subframes may be referred to as a "TTI," or one slot or one mini-slot may be referred to as a "TTI." In other words, at least one of a subframe or a TTI may be a subframe (1 ms) in the conventional LTE, may be a period shorter than 1 ms (for example, 1 to 13 symbols), or may be a period longer than 1 ms. It is to be noted that the unit representing TTI may be referred to as a slot, a mini-slot, or the like, instead of a subframe.

Here, a TTI refers to the minimum time unit of scheduling in radio communication, for example. For example, in LTE systems, a base station performs, for each terminal 20, scheduling of allocating radio resources (such as a frequency bandwidth and transmission power that can be used by each terminal 20) in TTI units. It is to be noted that the definition of the TTI is not limited to the above-described definition.

The TTI may be a transmission time unit for channel-encoded data packets (transport blocks), code blocks, codewords, or the like, or may be a unit of processing in scheduling, link adaptation, or the like. It is to be noted that, when a TTI is provided, a time period (for example, the number of symbols) to which transport blocks, code blocks, codewords, or the like are actually mapped may be shorter than the TTI.

It is to be noted that, in a case where one slot or one mini-slot is referred to as a TTI, one or more TTIs (that is, one or more slots or one or more mini-slots) may be the minimum time unit of scheduling. Furthermore, the number of slots (the number of mini-slots) constituting the minimum time unit of the scheduling may be controlled.

A TTI having a time length of 1 ms may be referred to as a normal TTI (TTI in LTE Rel. 8 to Rel. 12), a long TTI, a normal subframe, a long subframe, a slot, or the like. A TTI that is shorter than a normal TTI may be referred to as a "shortened TTI," a "short TTI," a "partial or fractional TTI," a "shortened subframe," a "short subframe," a "mini-slot," a "sub-slot," a "slot" and so on.

It is to be noted that a long TTI (for example, a normal TTI, a subframe, or the like) may be interpreted as a TTI having a time length exceeding 1 ms, and a short TTI (for example, a shortened TTI or the like) may be interpreted as a TTI having a TTI length shorter than the TTI length of a long TTI and having a TTI length equal to or longer than 1 ms.

A resource block (RB) is the unit of resource allocation in the time domain and the frequency domain, and may include one or a plurality of consecutive subcarriers in the frequency domain. The number of subcarriers included in an RB may be the same regardless of the numerology, and may be 12, for example. The number of subcarriers included in an RB may be determined based on the numerology.

In addition, an RB may include one or a plurality of symbols in the time domain, and may have a length of one slot, one mini-slot, one subframe, or one TTI. One TTI, one subframe, and the like, may each be constituted of one or a plurality of resource blocks.

Note that one or a plurality of RBs may be referred to as a "physical resource block (Physical RB (PRB))," a "sub-carrier group (SCG)," a "resource element group (REG),"a "PRB pair," an "RB pair" and so on.

Furthermore, a resource block may be constituted of one or a plurality of resource elements (REs). For example, one RE may correspond to a radio resource area including one subcarrier and one symbol.

A bandwidth part (BWP) (which may be referred to as a "fractional bandwidth," and so on) may represent a subset of contiguous common resource blocks (common RBs) for certain numerology in a certain carrier. Here, a common RB may be identified by an RB index based on the common reference point of the carrier. PRBs may be defined by a certain BWP and may be numbered in the BWP.

A BWP may include a BWP for UL (UL BWP) and a BWP for DL (DL BWP). One or a plurality of BWPs may be configured in one carrier for UE.

At least one of configured BWPs may be active, and the UE is not required to expect to transmit/receive a certain signal/channel outside the active BWP. It is to be noted that that a "cell", a "carrier", or the like, in the present disclosure may be interpreted as a "BWP".

Note that the above-described structures of radio frames, subframes, slots, mini-slots, symbols, and so on are merely examples. For example, structures such as the number of subframes included in a radio frame, the number of slots per subframe or radio frame, the number of mini-slots included in a slot, the numbers of symbols and RBs included in a slot or a mini-slot, the number of subcarriers included in an RB, the number of symbols in a TTI, the symbol length, the cyclic prefix (CP) length, and so on can be variously changed.

In the present disclosure, where an article is added by translation, for example "a", "an", and "the", the disclosure may include that the noun following these articles is plural.

In this disclosure, the term "A and B are different" may mean "A and B are different from each other." It should be noted that the term "A and B are different" may mean "A and B are different from C." Terms such as "separated" or "combined" may be interpreted in the same way as the above-described "different".

An aspect/embodiment described in the present specification may be used independently, may be used in combination, or may be used by switching according to operations. Further, notification (transmission/reporting) of predetermined information (e.g., notification (transmission/reporting) of "X") is not limited to an explicit notification (transmission/reporting), and may be performed by an implicit notification (transmission/reporting) (e.g., by not performing notification (transmission/reporting) of the predetermined information).

As described above, the present invention has been described in detail. It is apparent to a person skilled in the art that the present invention is not limited to one or more embodiments of the present invention described in the present specification. Modifications, alternatives, replacements, etc., of the present invention may be possible without departing from the subject matter and the scope of the present invention defined by the descriptions of claims. Therefore, the descriptions of the present specification are for illustrative purposes only, and are not intended to be limitations to the present invention.

### DESCRIPTION OF THE REFERENCE NUMERALS

10 Base station
110 Transmission unit
120 Reception unit
130 Configuration unit
140 Control unit
20 Terminal
210 Transmission unit
220 Reception unit
230 Configuration unit
240 Control unit
1001 Processor
1002 Memory
1003 Storage
1004 Communication apparatus
1005 Input apparatus
1006 Output apparatus

## Claims

1. A communication device comprising:
a control unit configured to perform coding of information bits by using Polar codes; and
a transmission unit configured to transmit coded words corresponding to the information bits to another communication device, wherein
the control unit determines positions of known bits that are added at a time of the coding of the information bits, based on a specific condition.

2. The communication device as claimed in claim 1, wherein
the control unit determines the positions of the known bits, based on a length of the coded words.

3. The communication device as claimed in claim 1, wherein
the control unit determines the positions of the known bits corresponding to Brief Propagation Decoding in a case where a length of the coded words is greater than a certain value.

4. The communication device as claimed in claim 1, wherein
the control unit determines the positions of the known bits corresponding to Successive Cancellation Decoding in a case where a length of the coded words is not greater than a certain value.

5. The communication device as claimed in claim 1, further comprising:
a reception unit configured to receive coded words that are coded according to the Polar codes, wherein
the control unit determines a number of iterations in Brief Propagation Decoding applied to the received coded words, based on a specific condition.

6. A communication method performed by a communication device, the communication method comprising:
performing coding of information bits by using Polar codes;
transmitting coded words corresponding to the information bits to another communication device; and
determining positions of known bits that are added at a time of the coding of the information bits, based on a specific condition.
